Europäisches Patentamt

European Patent Office

Office européen des brevets

(11) Veröffentlichungsnummer: **0 236 938**
**A2**

(12) **EUROPÄISCHE PATENTANMELDUNG**

(21) Anmeldenummer: 87103093.8

(51) Int. Cl.⁴: **H01L 31/02** , H01L 31/18

(22) Anmeldetag: 04.03.87

(30) Priorität: 11.03.86 DE 3608033

(43) Veröffentlichungstag der Anmeldung:
16.09.87 Patentblatt 87/38

(84) Benannte Vertragsstaaten:
DE FR GB

(71) Anmelder: **Siemens Aktiengesellschaft Berlin und München**
**Wittelsbacherplatz 2**
**D-8000 München 2(DE)**

(72) Erfinder: **Juergens, Wilfried, Dipl.-Phys.**
**Kastellburgstrasse 87**
**D-8000 München 60(DE)**
Erfinder: **Günzel, Eberhardt, Dr.**
**Ottobrunner Strasse 101**
**D-8000 München 83(DE)**

(54) **Verfahren zur Vermeidung von Kurzschlüssen bei der Herstellung von Dünnschichtsolarzellen aus amorphem Silizium.**

(57) Bei der Herstellung von mit Fingerelektroden-strukturen (7) versehenen Dünnschichtsolarzellen aus amorphem Silizium werden die durch Fehlstellen (5) im amorphen Silizium (4) verursachten Kurz-schlüsse zwischen Grund-und Deckelektroden dadurch vermieden, daß zwischen der Grundelektrodenschicht (2) und der Deckelektroden-schicht (6) zumindest im Bereich der Fingerelektro-denstruktur (7) vor oder nach der Herstellung der aktiven amorphen Siliziumschichten (4) eine Isola-tionszone (11) durch zusätzliches Erzeugen einer Oxidschicht (3, 13) oder durch Wegätzen der Grundelektrodenschicht (2) erzeugt wird. Das Verfah-ren wird verwendet bei der Herstellung von großflächigen Solarzellen aus amorphem Silizium.

## FIG 10

EP 0 236 938 A2

## Verfahren zur Vermeidung von Kurzschlüssen bei der Herstellung von Dünnschichtsolarzellen aus amorphem Silizium.

Die Erfindung betrifft ein Verfahren zur Vermeidung von Kurzschlüssen bei der Herstellung von elektrische Kontakte bildenden Fingerelektrodenstrukturen an aus amorphem Siliziumschichten bestehenden Dünnschichtsolarzellen, die durch Abscheiden der Schichtenfolge: Grundelektrode -aktive amorphe Siliziumschichten -Deckelektrode auf großflächigen Substraten erzeugt werden.

Dünnschichtsolarzellen aus amorphem Silizium und ihre Wirkungsweise sind beispielsweise aus dem Buch "Amorphe und polykristalline Halbleiter" von W. Heywang, aus der Serie "Halbleiter-Elektronik", Band 18, Springer Verlag (1984) auf den Seiten 58 bis 64, zu entnehmen.

Bei großflächigen Solarzellen können erhebliche Ströme entstehen -so zum Beispiel bei einem Wirkungsgrad $\eta$ von 10 Prozent, einer Standardbeleuchtung von 100 mW/cm² und 10 $^{\times}$ 10 cm² Fläche größer als 1,5 Ampere -, so daß bei Serien-oder Übergangswiderständen nicht mehr vernachläßigbare ohmsche Verluste auftreten. Bei Dünnschichtsolarzellen können, wenn die aktive Halbleiterschicht die Grundelektrode nicht dicht abdeckt (Fehlstellen im amorphen Silizium), zwischen der oberen und unteren Elektrode Kurzschlüsse auftreten, die den Wirkungsgrad der Zellen erheblich beeinflussen.

Um den Serienwiderstand von Solarzellen zu verringern, werden sogenannte Fingerelektrodenstrukturen (grids) auf den Zellen aufgebracht; eine solche Solarzellenstruktur mit der Schichtenfolge: Substrat -Grundelektrode -amorphes Silizium (nip) - semitransparente Deckelektrode -Gridelektrode ist beispielsweise aus der europäischen Patentanmeldung 0 060 363 A1 bekannt. Kurzschlüsse zwischen Grundelektrode und der gut leitenden Deckelektrode im Bereich der Fingerelektrodestruktur sind besonders kritisch und können die Zellen unbrauchbar machen.

Um diese Schwierigkeiten zu umgehen, hat man bislang versucht, entweder durch Anlegen einer Spannung an die Deck-und Grundelektrode die Kurzschlüsse wegzubrennen, oder nach Feststellen der Fehlstelle im Silizium mit einem Sensor die Deck-und/oder Grundelektrode mit einem Laser zu entfernen (Wegbrennen). Die erstgenannte Methode hat den Nachteil, daß die Fehlstelle nicht zu hochohmig sein darf, damit ein genügend hoher Strom fließen kann; die zweite Methode ist aufwendig und sehr teuer.

Aufgabe der Erfindung ist es, die durch Fehlstellen, die bei der Abscheidung im amorphen Silizium entstehen können, bedingten Kurzschlüsse in wenig aufwendiger Weise und sicher zu unterbinden.

Diese Aufgabe wird erfindungsgemäß dadurch gelöst, daß zwischen Grundelektrode und Deckelektrode vor oder nach der Herstellung der aktiven amorphen Siliziumschichten zumindest im Bereich der späteren Fingerelektrodenstruktur eine Isolationszone erzeugt wird.

Dabei liegt es im Rahmen der Erfindung, daß entweder die Grundelektrodenschicht vor der Abscheidung der amorphen Siliziumschichten im Bereich der später zu erzeugenden Fingerelektrodenstruktur mit einer isolierenden Schichtstruktur versehen wird, wobei die Isolationsschichtstruktur zum Beispiel aus Siliziumoxid (SiO$_x$ ) besteht oder durch selektive Oxidation der Grundelektrodenschicht erzeugt wird, oder daß bei Vorliegen einer Dünnschicht solarzelle mit der speziellen Struktur: Metall -(nip) a-Si -transparente Deckelektrode - Metallgrid die Grundelektrodenschicht ganzflächig mit einer Ventilmetallschicht beschichtet wird, die nach Abscheiden der amorphen Siliziumschichten unter Verwendung einer Elektrolytlösung einem anodischen Oxidationsprozeß unterworfen wird. Dabei wird als Ventilmetall vorzugsweise Tantal und als Elektrolytlösung wäßrige Phosphorsäurelösung verwendet; die Schichtdicke der Tantalschicht wird auf ca. 10 nm eingestellt.

Eine weitere Möglichkeit ist dadurch gegeben, daß nach dem Abscheiden der amorphen Siliziumschicht auf die Grundelektrodenschicht ein Ätzprozeß mit einem nur die Grundelektrodenschicht, nicht aber amorphes Silizium angreifende Ätzmittel solange durchgeführt wird, bis das Substrat an den Fehlstellen im amorphen Silizium freigeätzt ist und daß dann nach Entfernung der Ätzmittelreste ganzflächig die Deckelektrodenschicht aufgebracht wird. Letztere Methode ist am einfachsten durchführbar.

Weitere Ausgestaltungen der Erfindung ergeben sich aus den Unteransprüchen.

Im folgenden wird anhand der Figuren 1 bis 10 die Erfindung noch näher erläutert. Dabei zeigen die Figuren im Schnittbild die erfindungswesentlichen Verfahrensschritte, wobei

die Figur 1 bis 4 die Variante der zusätzlich erzeugten Isolationsschicht,

die Figuren 5 bis 7 die Variante mit der durch anodische Oxidation erzeugten Isolationsschicht und

die Figuren 8 bis 10 die Variante mittels eines spezifischen Ätzprozesses darstellen.

Gleiche Teile sind in allen Figuren mit gleichen Bezugszeichen versehen.

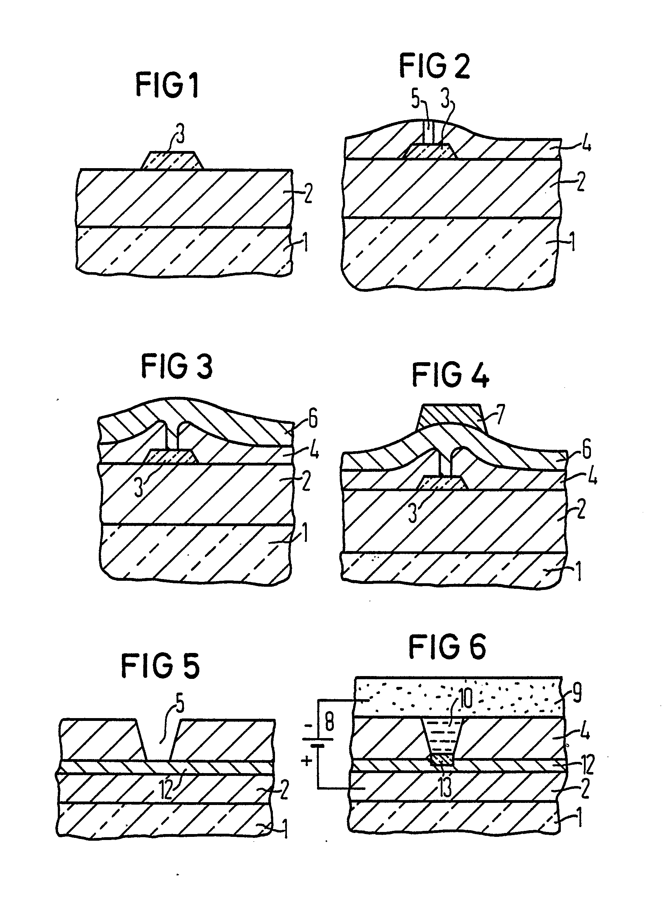

Figur 1: Auf einem, zum Beispiel aus Glas bestehendem transparenten Substrat 1 wird ganzflächig die aus zum Beispiel Metall wie Nickel/Chrom oder Silber bestehende Grundelektrodenschicht 2 aufgedampft, welche an den unter den später aufzubringenden Gridstrukturen (7) liegenden Bereichen mit einer SiO$_2$-Schicht 3 versehen wird.

Figur 2: Auf diese Anordnung (1, 2, 3) wird die aus amorphem Silizium bestehende aktive Halbleiterschicht 4 der Solarzelle mit der Schichtenfolge pin oder nip (in den Figuren nicht im Detail dargestellt) aufgebracht. An der mit dem Pfeil 5 bezeichneten Stelle hat sich beispielsweise in der amorphen Siliziumschicht eine Fehlstelle bzw. Loch gebildet, die einen Kurzschluß der beiden Elektroden (2, 6) der Solarzelle auslösen kann.

Figur 3: Die mit der Fehlstelle 5 behaftete amorphe Siliziumschicht 4 wird ganzflächig mit der Deckelektrodenschicht 6, bestehend aus zum Beispiel mit Indium dotiertem Zinnoxid (ITO) versehen.

Figur 4: Abschließend wird auf der Deckelektrodenschicht 6 das Fingerelektrodensystem 7 (Grid) aus zum Beispiel Palladium oder einer Nickel-Chrom-Legierung erzeugt. Wie aus der Figur 4 zu ersehen ist, wird die Grundelektrode 2 unter dem Grid 7 durch eine Isolationsschicht 3 von der Deckelektrode 6 getrennt, so daß an den kritischen Stellen (unter dem Grid 7) keine Kurzschlüsse mehr auftreten können.

Figur 5: Für die spezielle Struktur: Metall (2) -amorphe Siliziumschicht (4) mit der Schichtenfolge nip -Deckelektrode (6) aus mit Indium dotiertem Zinnoxid (ITO) - Metallgrid (7) gibt es eine weitere Methode, Kurzschlüsse zu verhindern. In diesem Fall wird auf die Metallgrundelektrodenschicht 2 eine zum Beispiel ca. 10 nm dünne Tantalschicht 12 aufgebracht und auf dieser dann die amorphe Siliziumschicht 4 in nip-Struktur erzeugt. An der mit dem Pfeil 5 gekennzeichneten Stelle soll sich ein Loch befinden.

Figur 6: Anschließend wird die Siliziumoberfläche 4 mit der Fehlstelle bzw. dem Loch 5 mit einer wäßrigen Phosphorsäure-Elektrolytlösung kontaktiert, was zum Beispiel mit Hilfe eines getränkten Fließpapiers 9 geschehen kann, wobei überschüssige Elektrolytlösung 10 in die Fehlstelle 5 eindringt. Wird nun die Metallgrundelektrode 2 gegenüber der Elektrolytlösung 10 mit Hilfe einer externen Spannungsquelle 8 anodisch geschaltet, so fließt nur über die Fehlstelle 5 ein Strom, da das Silizium 4 selbst in Sperr-Richtung gepolt ist. Der durch die Fehlstelle 5 fließende Strom erzeugt auf dem Tantal 12 ein isolierendes, anodisches Tantaloxid 13, welches Kurzschlüsse mit der Grundelektrode 2 verhindert.

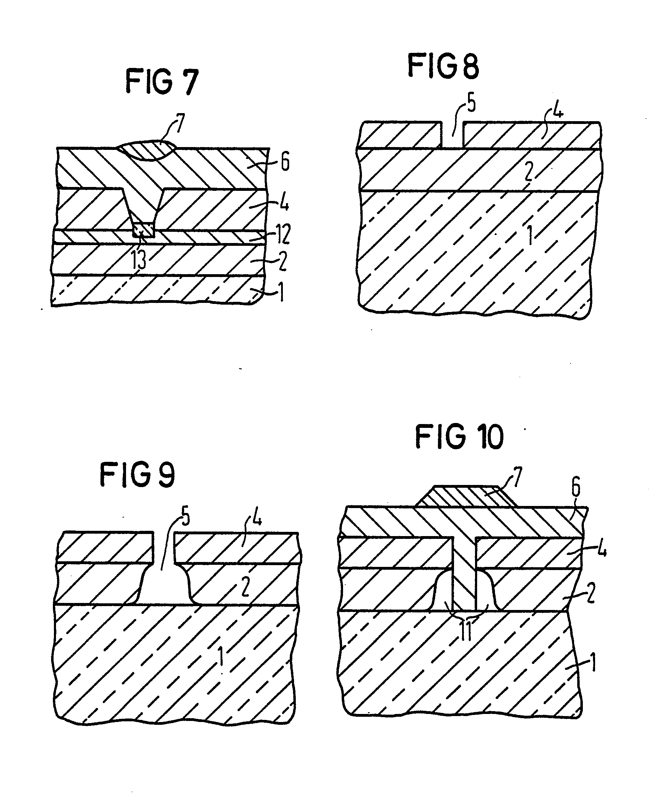

Figur 7: Nach einem Sprühprozeß wird die aus Indium-Zinnoxid bestehende Schicht 6 (ITO-Schicht) und das Grid 7 aufgebracht.

Figur 8: Nach Aufbringen der amorphen Siliziumschichtfolge 4 (pin oder nip) auf eine darunterliegende Grundelektrode 2 aus Metall oder einem transparenten leitenden Oxid (TCO = transparent conductive oxid) wie zum Beispiel mit Fluor dotiertem Zinnoxid, wird die -noch nicht fertige - Zelle gereinigt und mit einem Ätzmittel geätzt, welches nur die Grundelektrodenschicht 2, nicht aber die aktive (a-Si-)-Schicht 4 wegätzt.

Figur 9: Die Grundelektrodenschicht 2 darf hier nur so dick sein, daß sie noch weggeätzt werden kann. Die Ätze greift bei Fehlstellen - (Löchern) 5 an; im Ausführungsbeispiel besteht die Grundelektrodenschicht 2 aus einer Nickel-Chrom-Legierung (60:40) und das Ätzmittel aus einer salpetersauren Cersulfatlösung.

Figur 10: Eine anschließend nach einem Waschprozeß aufgebrachte Deckelektrodenschicht 6 aus TCO oder Metall kann dann, bedingt durch die Isolationszone 11, die durch das Abätzen der Grundelektrodenschicht 2 unterhalb der Fehlstelle 5 im amorphen Silizium 4 entstanden ist, zu keinem Kurzschluß mehr führen.

**Ansprüche**

1. Verfahren zur Vermeidung von Kurzschlüssen bei der Herstellung von elektrische Kontakte bildenden Fingerelektrodenstrukturen an aus amorphen Siliziumschichten (4) bestehenden Dünnschichtsolarzellen, die durch Abscheiden der Schichtenfolge: Grundelektrode (2) -aktive amorphe Siliziumschichten (4) -Deckelektrode (6) auf großflächigen Substraten (1) erzeugt werden, **dadurch gekennzeichnet**, daß zwischen Grundelektrode (2) und Deckelektrode (6) vor oder nach der Herstellung der aktiven amorphen Siliziumschichten (4) zumindest im Bereich der späteren Fingerelektrodenstruktur (7) eine Isolationszone - (11) erzeugt wird.

2. Verfahren nach Anspruch 1, **dadurch gekennzeichnet**, daß die Grundelektrodenschicht (2) vor der Abscheidung der amorphen Siliziumschichten (4) im Bereich der später zu erzeugenden Fingerelektrodenstruktur (7) mit einer isolierenden Schichtstruktur (3) versehen wird.

3. Verfahren nach Anspruch 1 oder 2, **dadurch gekennzeichnet**, daß die Isolationsschichtstruktur (3) aus Siliziumoxid (SiO$_x$) besteht. -

4. Verfahren nach Anspruch 1 oder 2, **dadurch gekennzeichnet**, daß die Isolationsschichtstruktur (3) durch selektive Oxidation der Grundelektrodenschicht (2) erzeugt wird.

5. Verfahren nach Anspruch 1, **dadurch gekennzeichnet**, daß bei Vorliegen einer Dünnschicht-Solarzelle mit der nip-Schichtstruktur (4) die Grundelektrodenschicht (2) ganzflächig mit einer Ventilmetallschicht (12) beschichtet wird, die nach Abscheiden der amorphen Siliziumschichten (4) unter Verwendung einer Elektrolytlösung (10) einem anodischen Oxidationsprozeß unterworfen wird.

6. Verfahren nach Anspruch 5, **dadurch gekennzeichnet**, daß als Ventilmetall (12) Tantal und als Elektrolytlösung (10) wäßrige Phosphorsäure ($H_3PO_4$) verwendet wird.

7. Verfahren nach Anspruch 6, **dadurch gekennzeichnet**, daß die Schichtdicke der Tantalschicht (12) auf ca. 10 nm eingestellt wird.

8. Verfahren nach Anspruch 1, **dadurch gekennzeichnet**, daß nach dem Abscheiden der amorphen Siliziumschicht (4) auf die Grundelektrodenschicht (2) ein Ätzprozeß mit einem nur die Grundelektrodenschicht (2), nicht aber amorphes Silizium (4) angreifenden Ätzmittel solange durchgeführt wird, bis das Substrat (1) an den Fehlstellen (5) im amorphen Silizium (4) freigeätzt ist und daß dann nach Entfernung der Ätzmittelreste ganzflächig die Deckelektrodenschicht (6) aufgebracht wird.

9. Verfahren nach Anspruch 8, **dadurch gekennzeichnet**, daß die Grundelektrodenschicht (2) aus Metall und die Deckelektrodenschicht (6) aus einem transparenten leitenden Oxid, vorzugsweise aus mit Fluor dotiertem Zinnoxid besteht.

10. Verfahren nach Anspruch 8 oder 9, **dadurch gekennzeichnet**, daß bei Vorliegen einer, aus einer Nickel-Chrom-Legierung zum Beispiel im Verhältnis 60:40 vorliegenden Grundelektrodenschicht (2) als Ätzmittel eine salpetersaure Cersulfatlösung oder eine Mischung aus Salzsäure, Äthylenglykol und Nickel (II)-Chlorid verwendet wird.

FIG 1

FIG 2

FIG 3

FIG 4

FIG 5

FIG 6

FIG 7

FIG 8

FIG 9

FIG 10